Europäisches Patentamt

European Patent Office

Office européen des brevets

(11) Publication number: **0 130 508**
A1

# EUROPEAN PATENT APPLICATION

(21) Application number: **84107208.5**

(22) Date of filing: **22.06.84**

(51) Int. Cl.⁴: **H 01 L 29/08, H 01 L 29/78**

(30) Priority: **30.06.83 JP 118827/83**

(71) Applicant: **NISSAN MOTOR COMPANY, LIMITED, No.2, Takara-cho, Kanagawa-ku, Yokohama-shi Kanagawa-ken 221 (JP)**

(43) Date of publication of application: **09.01.85 Bulletin 85/2**

(72) Inventor: **Tominaga, Tamotsu, 15-31-1007, Higashi-cho Isogo-ku, Yokohama-shi Kanagawa-ken (JP)**
Inventor: **Mihara, Teruyoshi, 1-16, 13-305, Futaba, Yokosuka-shi Kanagawa-ken (JP)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22 (DE)**

(84) Designated Contracting States: **DE FR GB**

(54) **Field effect transistor of the vertical MOS type.**

(57) A vertical MOS transistor comprises a first well region on an upper side of a semiconductor substrate, a second well region of a conductivity opposite to that of the first well region, which is provided within the first well region. Both well regions are formed by a double diffusion through the same diffusion window designed so that each angle formed by two adjacent sides is 150° or more. For instance, a 12-sided polygon 18-sided polygon or a circle is used for the diffusion window. Thus, it is easily possible to a vertical MOS transistor having low on-voltage and on-resistance, and high switching capability.

EP 0 130 508 A1

## TITLE OF THE INVENTION
### FIELD EFFECT TRANSISTOR OF THE VERTICAL MOS TYPE

BACKGROUND OF THE INVENTION

(Technical field of the invention)

The present invention relates to a vertical metal oxide silicon field effect transistor having low on-voltage and on-resistance, and high speed switching capability.

(Prior art)

A conventional vertical MOS transistor of this kind is described in "HEX FET DATABOOK (International Rectifier Company) p. 6 to 7".

A method of fabricating such a MOS transistor will be described with reference to Figs. 1A to 1J.

Initially, at a first step, as shown in Fig. 1A, a semiconductor substrate provided with an epitaxial layer 1 of an N-type having a specific resistance of $2\,\Omega\,cm$ and a thickness of $15\,\mu m$ is prepared on the upper surface of a silicon wafer 1 having a surface direction (100) of a crystal axis, a specific resistance of 0.01 cm and a thickness of $380\,\mu m$. On the upper side of the semiconductor substrate, a gate oxide film 3 of $SiO_2$ having a thickness of $10^2$ nm (nano meter), i.e. $1000\text{Å}$ and a field oxide film 4 of $SiO_2$ having a thickness of $7 \times 10^2$ nm ($7000\text{Å}$) are provided.

The condition for fabricating the gate oxide film 3 is to effect an oxidation in the atmosphere of $O_2$ gas at a temperature of 1050°C about 90 min. (minutes).

Then, at a second step, as shown in Fig. 1B a $4.5 \times 10^2\,\mu$ m-thick gate electrode 5 of a polysilicon forming a plurality of gates is provided on the gate oxide film 3. In the gate electrode area, a pluraliry of polygonal diffusion windows 6 for forming a P-well and an $N^+$-well which will be described later are opened so that each window is located apart from each other by a predetermined distance.

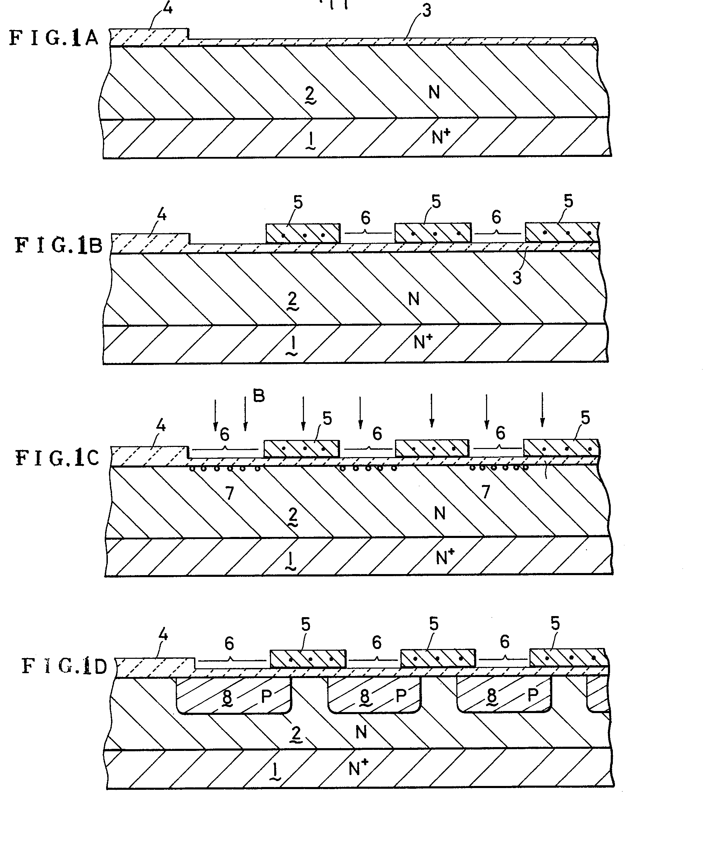

At a third step $S_3$, as shown in Fig. 1C, with the gate electrode 5 serving as a mask, a predetermined quantity of $B^+$ ions 6 are implanted into the surface layer of the epitaxial layer 2 directly located below each diffucion window 6 with its ion implantation condition where an acceleration voltage is 60 KeV and a density is $1 \times 10^{14}$ atoms/$cm^2$ .

At a fourth step, as shown in Fig. 1D, P-wells 8 are formed by diffusing a predetermined quantity of $B^+$ ions in the atmosphere of $N_2$ gas at a temperature of $1120^{\circ}C$, about 24 hours so that the thickness thereof is approximately 5 $\mu$m.

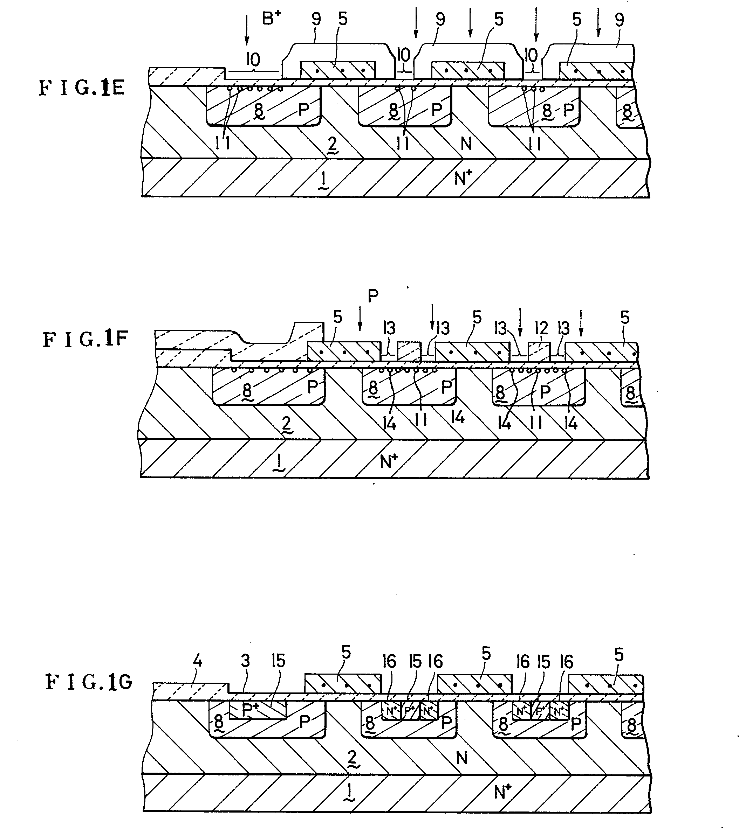

At a fifth step, as shown in Fig. 1E, with resists 9 serving as masks covering the peripheral portion of each diffusion window 6, a predetermined quantity of $B^+$ ions are implanted from window 10 formed in the center thereof with its ion implantation condition where an acceleration voltage is 45 Kev and a density is about $5 \times 10^{15}$ atoms/$cm^2$.

At a sixth step, in contrast to the fifth step, solely the central portion of each diffusion window 6 is covered with a resist 12 serving as a mask. Thereafter, from windows 13 formed along the periphery of diffusion windows 6, a predetermined quantity of $P^+$ ions (phosphorus ions) is implanted with ion implantation condition where an acceleration voltage is 110 KeV and a density is $5 \times 10^{15}$ atoms/$cm^2$.

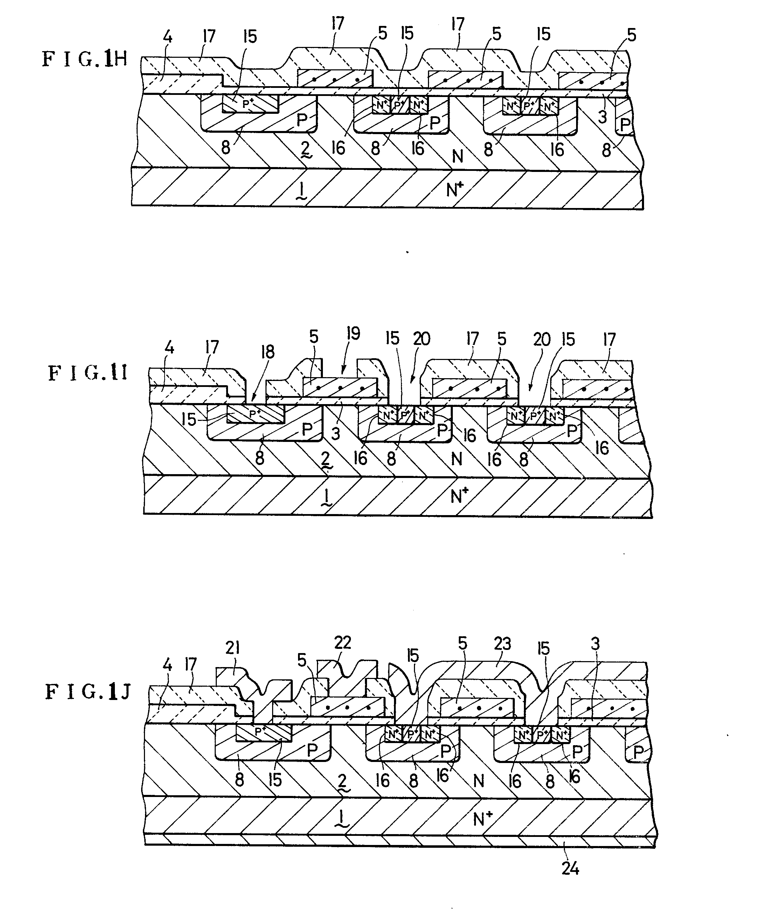

At a seventh step, as shown in Fig. 1G, by effecting a thermal diffusion at a temperature of $1080^{\circ}C$ about 20 min. in the atmosphere of $N_2$ gas, $P^+$ wells 15 serving as contact regions and $N^+$-wells 16 serving as source regions are formed so that each diffusion depth is about 1 $\mu$m.

At a eighth step, as shown in Fig. 1H, the whole surface of the substrate is covered by an intermediate insulating film 17 of phosphorous glass having a thickness of $7 \times 10^2$ nm (7000Å).

At a ninth step, as shown in Fig. 1I, a suitable number

contact holes 18, 19 and 20 respectively required for mounting a channel stopper electrode, a gate electrode and a source electrode are opened in the intermediate insulating film 17.

Finally, at a tenth step, as shown in Fig. 1J, Al (aluminum) is vacuum-deposited on the both sides of the substrate and selectively removed thereafter so that the thickness thereof is approximately 2 m to form a channel stopper electrode 21, a gate electrode 22, a source electrode 23 and a drain electrode 24, respectively. Thus, an elementary structure of the vertical MOS transistor is completed.

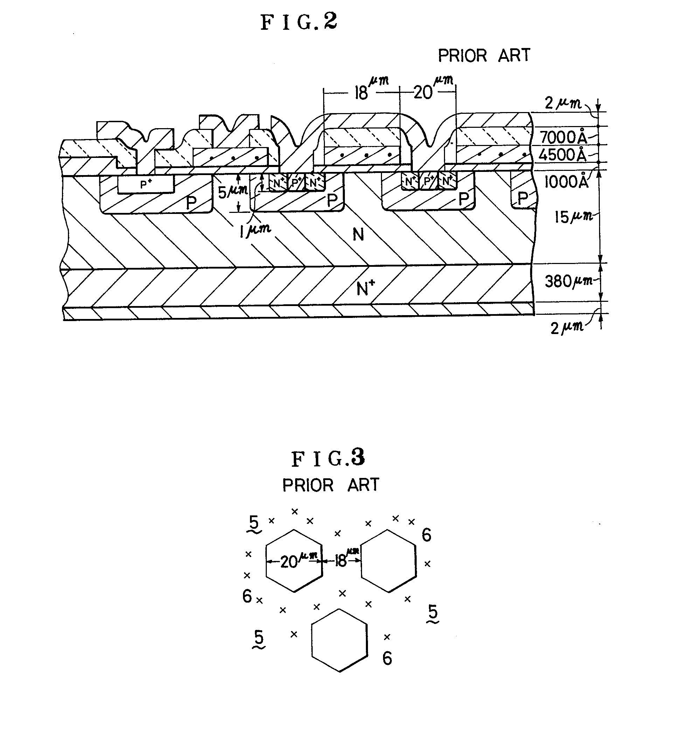

An example of the product of the vertical MOS transistor thus fabricated through the above-mentioned steps is shown in Fig. 2, and the geometric arrangement and configuration of the diffusion windows 6 as apertures in the gate electrode 5 is shown in Fig. 3. This vertical MOS transistor is formed such that a plurality of hexagonal diffusion windows 6 as shown in Fig. 3 are arranged in the gate electrode 5 having a chip area of $1 \ mm^2$ to form the P-well and the $N^+$-well through each diffusion window 6 by making use of a double diffusion.

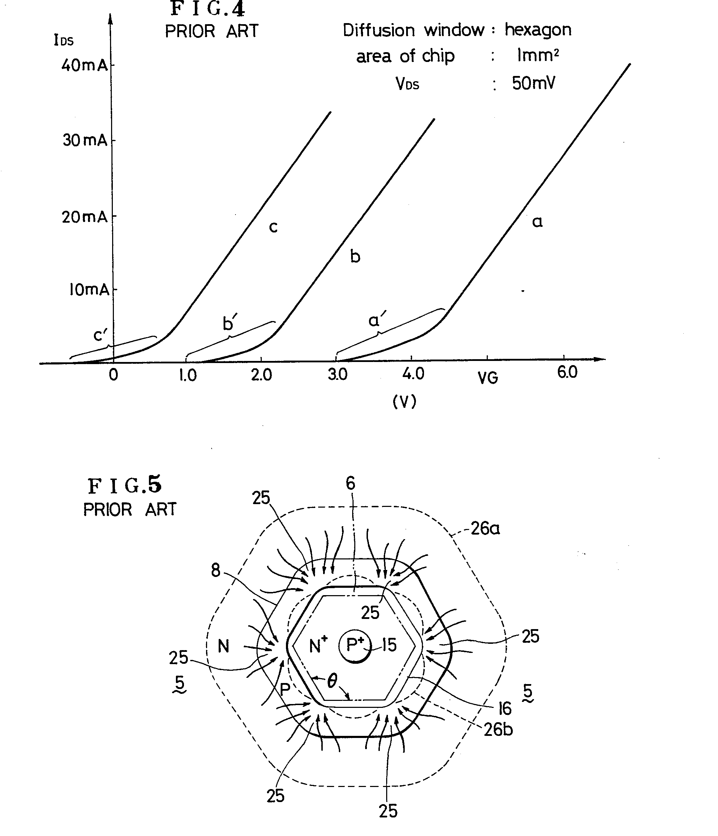

A $V_G - I_{DS}$ characteristic of this product is indicated by a curve $\underline{a}$ in a graph of Fig. 4. As is clear from the graph, the threshold voltage $V_T$ of this product is set to 3.0 volts.

As seen from the example of the product shown in Figs. 2 to 4, the vertical MOS transistor of this structure is such that it is easy to miniaturize a channel length thereof with a high precision. Accordingly, such vertical MOS transistors are fabricated for use in, e.g. a power switching element having low on-resistance. However, as compared with bipolar power transistors, such vertical MOS transistors have on-resistance two or three times higher than that of the bipolar transistors with both transistors being of the same chip size. Further, because such vertical MOS transistors have a threshold voltage $V_T$ of usually 2 to 5 volts, its driving voltage becomes high. For this reason, it is impossible to directly drive such vertical MOS transistors from an output of a TTL circuit.

0130508

Meanwhile, it is well known vertical MOS transistors of this kind have characteristics described below. One is that the value of the on-resistance is determined by a diffusion length in a lateral direction (a lateral diffusion length) of the P-well region 8, i.e. a channel length. Second is that the value of the threshold voltage $V_T$ is determined by a diffusion concentration of the P-well region 8. In view of this, this applicant foresaw that the reduction of both the on-resistance and the threshold voltage $V_T$ can be attained by reducing a lateral diffusion distance of the P-well region 6 and lowering a diffusion concentration.

Based on such a forecast, this applicant actually reduced the diffusion length of the P-well region 8 and lowers the diffusion concentration. As a result, there practically arise following problems. Namely, as shown in Fig. 4, for instance, in order to lower a threshold voltage $V_T$ to about 1.0 volt so that such vertical MOS transistors can be driven with a TTL circuit, if an attempt is made to reduce a lateral diffusion distance of the P-well region 8 and to lower the diffusion concentration, as shown in a curve b in Fig. 4, a $V_G - I_{DS}$ curve indicative of a prior art product indicated by a curve a is parallelly shifted in the left direction. In this instance, if an attention is drawn to initial regions a' and b' in respect of a current $I_{DS}$, it quite gently rises in either case. For this reason, there occurs the following phenomenon. Namely, it is possible to lower a gate voltage $V_G$ corresponding to the start of a current flow to 1.0 volt. However, since current increasing rate at a time immediately after the current rises is quite gentle, when such elements are applied to a power switching, there occurs a large switching time delay. Accordingly, it is impossible to practically use such elements.

When further lowering the concentration of the P-well region in order to steepen a rising of the current in the vicinity of $V_G$=1.0 volt, the gate voltage $V_G$ corresponding to the start of a current flow shows a negative value as indicated by a curve c in Fig. 4. This means that such elements functions as a depletion type MOS transistor. Namely, it is impossible to practically use them.

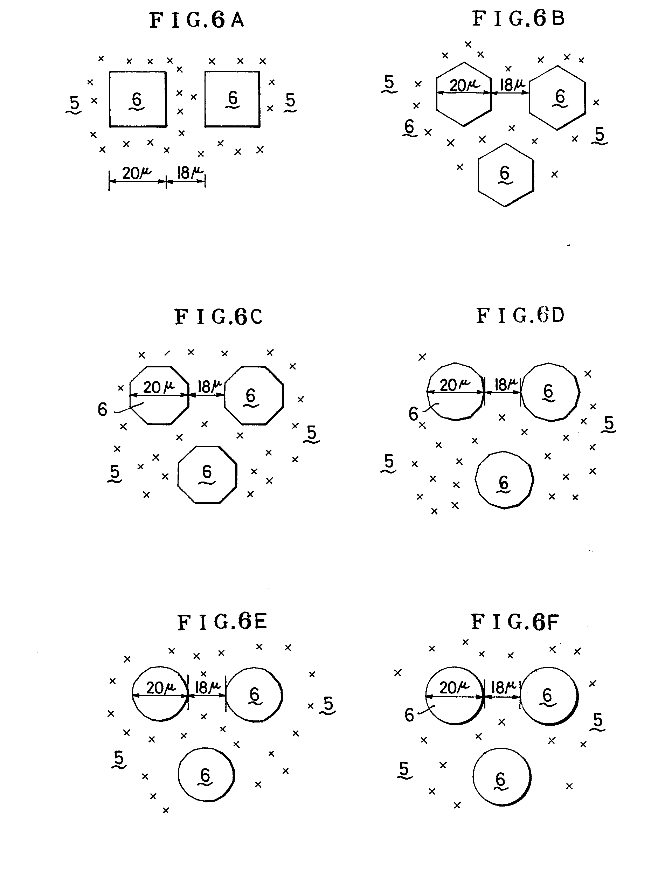

As a result of studies for investigating the cause, this applicant has found following facts. As shown in Fig. 5, in the fabricating process of this MOS transistor, the P-well regions 8 and the $N^+$ regions 16 are formed by making use of a double diffusion successively effected from the diffusion windows 6 opened in the gate electrode region. In this insance, at each vertex of the diffusion window 6, namely at a region 25 corresponding to each corner, the diffusion concentration locally lowers in either of the P-well and the $N^+$-well. For this reason, if an attempt is made to raise a gate voltage under application of a predetermined voltage between the drain and the source, depletion layer indicated with dotted lines 26a and 26b extends from the boundary of the P-well region 8 and the N-type region to or toward the inner and outer directions, respectively. As a result, the depletion layer expands to the $N^+$-well 16 locally in the vicinity of the corners 25 having a low concentration. Thus, depletion layer reaches the $N^+$-well at the corner 25 to produce a punch-through. Namely, before there occur conductive phenomena at six sides of the $N^+$-well 16, currents leak as indicated by an arrow in Figure at each corner 25. As a result, as shown in the graph of Fig. 4, there occur initial regions a', b' and c' having a low current change rate.

When further investigating the reason why a diffusion concentration lowers at each corner 25, it results from the fact that a diffusion speed in a lateral direction at each corner of the diffusion window 6 is lower that a each side thereof. It is confirmed that according as an angle defined or formed by two adjacent sides at each corner position becomes small, the above phenomenon more remarkably appears.

SUMMARY OF THE INVENTION

With the above in mind, an object of the present invention is to provide a field effect transistor of a vertical

- 6 -

0130508

MOS type having low on-voltage and on-resistance, and high speed switching capability.

To achive this object, there is provided a vertical MOS transistor according to the present invention comprising a semiconductor substrate of a first conductivity type, serving as a source or drain region, a first well region of a second conductivity type provided on an upper side of the semiconductor substrate, a second well region of a first conductivity type provided within the well region of the second conductivity type and serving as a source or drain region, and a gate electrode disposed on the surface of the first well region through an insulating film so as to extend over the semiconductor substrate of the first conductivity type and the second well region, characterised in that the well region is formed by a double diffusion through the same polygonal diffusion window in which each angle defined by two adjacent sides is larger than $150^{\circ}$.

BRIEF DESCRIPTION OF THE DRAWING

The features and advantages of a vertical type MOS transistor according to the present invention will become more apparent from the following description taken in conjunction with the accompanying drawings, in which:

Figs. 1A to 1J are views each illustrating fabricating process of a vertical type MOS transistor,

Fig. 2 is a cross sectional view illustrating an example of the prior art element with actual dimensions;

Fig. 3 is a plan view illustrating a diffusion window of the prior art product,

Fig. 4 is a graph showing a $V_G - I_{DS}$ characteristic of the prior art product,

Fig. 5 is a plan view illustrating a part along the periphery of the diffusion window for explaining the reason why the rising of $V_G - I_{DS}$ becomes gentle with the prior art product,

Figs. 6A to 6F are plan views each illustrating a diffusion window of the trial product used in an experiment in connection with the invention, and

Fig. 7 is a graph showing a comparison between the $V_G$ - $I_{DS}$ characteristic of the transistor of the invention and that of the prior art product.

## DESCRIPTION OF PREFERRED EMBODIMENTS

The preferred embodiments according to the present invention will be described with reference to accompanying drawings.

As supported by the description of the embodiments, the subject matter of the invention lies in that a P-well region and an $N^+$ region formed within a substrate provided with an epitaxial layer are formed by a double diffusion through the same polygonal diffusion window designed so that each angle formed by two adjacent sides is $150°$ or more.

By making use of the above-mentioned diffusion window of the inventive structure when effecting a double diffusion, the difference between a diffusion concentration of a P-well region corresponding to each corner of a diffusion window and that of side thereof sufficiently becomes small. Accordingly, there concurrently occur a punch-through at each corner and a channel conductive phenomenon at each side parts. For this reason, even if an attempt is made to reduce a diffusion distance in a lateral direction in order to reduce a threshold voltage and a channel length (i.e. lowering of a resistance), the rising in $V_G$ - $I_{DS}$ characteristic is relatively steep. As a result, it is possible to obtain a vertical MOS transistor having low on-voltage an on-resistance, and high speed switching capability.

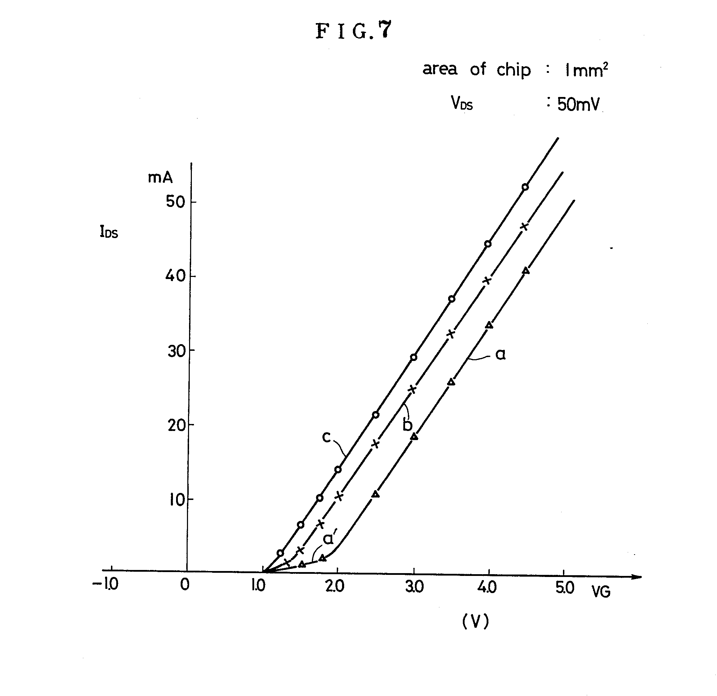

Referring to Fig. 7, there is shown a graph how the $V_G$ - $I_{DS}$ characteristic varies as an angle defined by two adjacent sides of a diffusion window 6 varies. Curve a displays the characteristic in the case that diffusion window is a quadrangle, hexagon or octagon as shown in Fig. 6A, 6B or 6C; Curve b, in the case that diffusion window is a twelve-sided polygon as shown in Fig. 6D; and Curve c, in the case that the diffusion window is an eighteen-sided polygon as shown in Fig. 6E.

The cross sectional structure and the dimension of each product are the same as those of the product shown in Fig. 2, except for the depth of a P-well. Further, the cross sectional structure and the dimension of the $N^+$ type silicon wafer and the N-type epitaxial layer are the same as those of the prior art product except for diffusion depth.

In each product, the diffusion condition of a P-well is controlled so that a threshold voltage $V_T$ becomes 1 volt. Other fabricating processes in connection therewith are the same as those shown in Fig. 1.

The trial fabrication conditions of each product are as follows:

(1) in the case of a quadrangular diffusion window
  a) gas oxidation; $O_2$, $1050^{\circ}C$, 10 nm (1000Å)
  b) P-well $B^+$ ion injection; 60 KeV, $5 \times 10^{13}$ atoms/$cm^2$
  c) P-well drive in; in the atmosphere of $N_2$ $1120^{\circ}C$, 20 hr.
  d) P-well diffusion depth; $3.7 \mu m$
  e) $P^+$ well $B^+$ ion injection; 45 KeV, $5 \times 10^{15}$ atoms/$cm^2$
  f) P+ well drive in; in the atmosphere of $N_2$, $1080^{\circ}C$, 20 min.
  g) $P^+$ well diffusion depth; $1 \mu m$
  h) $N^+$-well $P^+$ ion injection; 110 KeV, $5 \times 10^{15}$ atoms/$cm^2$
  i) $N^+$-well drive in; $1080^{\circ}C$, 20 min.
  j) $N^+$-well diffusion depth; $1 \mu m$

(2) In the case of hexagonal diffusion window
  a) gate oxidation; $O_2$, $1050^{\circ}C$, 10 nm (1000Å)
  b) P-well $B^+$ ion injection; 60 Kev, $5 \times 10^{13}$ atoms/$cm^2$
  c) P-well drive in; in the atmosphere of $N_2$, $1120^{\circ}C$, 20 hr.
  d) P-well diffusion depth; $3.7 \mu m$
  e) $P^+$ well $B^+$ ion injection; 45 KeV,

$5 \times 10^{15}$ atoms/cm$^2$

f) P$^+$ well drive in; in the atmosphere of N$_2$, 1080$^\circ$C, 20 min.

g) P$^+$ well diffusion depth; 1 $\mu$m

h) N$^+$-well P$^+$ ion injection; 110 Kev, $5 \times 10^{15}$ atoms/cm$^2$

i) N$^+$-well drive in; 1080$^\circ$C, 20 min.

j) N$^+$-well diffusion depth; 1 $\mu$m

(3) in the case of octagonal diffusion window

a) gate oxidation; O$_2$, 1050$^\circ$C, 10 nm (1000Å)

b) P-well B$^+$ ion injection; 60 KeV, $5 \times 10^{13}$ atoms/cm$^2$

c) P-well drive in; in the atmosphere of N$_2$, 1120$^\circ$C, 20 hr.

d) P-well diffusion depth; 3.7 $\mu$m

e) P$^+$ well B$^+$ ion injection; 45 KeV, $5 \times 10^{15}$ atoms/cm$^2$

f) P$^+$ well drive in; in the atmosphere of N$_2$, 1080$^\circ$C, 20 min.

g) P$^+$ well diffusion depth; 1 $\mu$m

h) N$^+$-well P$^+$ ion injection; 110 KeV, $5 \times 10^{15}$ atoms/cm$^2$

i) N$^+$-well drive in; 1080$^\circ$C, 20 min.

j) N$^+$-well diffusion depth; 1 $\mu$m

(4) in the case of twelve-sided polygonal diffusion window

a) gate oxidation; O$_2$, 1050$^\circ$C, 10 nm (1000Å)

b) P-well B$^+$ ion injection; 60 Kev, $4 \times 10^{13}$ atoms/cm$^2$

c) P-well drive in; in the atmosphere of N$_2$, 1120$^\circ$C, 20 hr.

d) P well diffusion depth; 3.6 $\mu$m

e) P$^+$ well B$^+$ ion injection; 45 KeV, $5 \times 10^{15}$ atoms/cm$^2$

f) P$^+$ well drive in; in the atmosphere of N$_2$,

1080°C, 20 min.

g) $P^+$ well diffusion depth; $1\mu m$

h) $N^+$-well $P^+$ ion injection; 110 KeV, $5\times10^{15}$ atoms/$cm^2$

i) $N^+$-well drive in; 1080°C, 20 min.

j) $N^+$-well diffusion depth; $1\mu m$

(5) in the case of eighteen-sided polygonal diffusion window

a) gate oxidation; $O_2$, 1050°C, 10 nm (1000Å)

b) P-well $B^+$ ion injection; 60 KeV, $3\times10^{13}$ atoms/$cm^2$

c) P-well drive in; in the atmosphere of $N_2$, 1120°C, 20 hr.

d) P-well diffusion depth; $3.5\mu m$

e) $P^+$ well $B^+$ ion injection; 45 KeV, $5\times10^{15}$ atoms/$cm^2$

f) $P^+$ well drive in; in the atmosphere of $N_2$, 1080°C, 20 min.

g) $P^+$ well diffusion depth; $1\mu m$

h) $N^+$-well $P^+$ ion injection; 110 KeV, $5\times10^{15}$ atoms/$cm^2$

i) $N^+$-well drive in; 1080°C, 20 min.

j) $N^+$-well diffusion depth; $1\mu m$

(6) in the case of circular diffusion window

a) gate oxidation; $O_2$, 1050°C, 10 nm (1000Å)

b) P-well $B^+$ ion injection; 60 KeV, $3\times10^{13}$ atoms/$cm^2$

c) P-well drive in; in the atmosphere of $N_2$, 1120°C, 20 hr.

d) P-well diffusion depth; $3.5\mu m$

e) P-well $B^+$ ion injection; 45 KeV, $5\times10^{15}$ atoms/$cm^2$

f) $P^+$ well drive in; in the atmosphere of $N_2$, 1080°C, 20 min.

g) $P^+$ well diffusion depth; $1\mu m$

h) $N^+$-well $P^+$ ion injection; 110 KeV, $5 \times 10^{15}$ atoms/$cm^2$

i) $N^+$-well drive in; 1080°C, 20 min.

j) $N^+$-well diffusion depth; 1 $\mu$m

According to trial manufacturing condition, as shown in Fig. 7, the threshold voltage $V_T$ of each product becomes 1 volt. When the diffusion window is a quadrangular, hexagonal and octagonal in shape, there exists a gently sloping initial region a' in a rising area of the current $I_{DS}$, resulting in deterioration of switching response.

On the contrary, when the diffusion window is a twelve-sided polygon, as indicated by a curve b, the rising of the current $I_{DS}$ is relatively improved. Further, when the diffusion window is an eighteen-sided polygon or a circle, as indicated by a curve c, it is possible to obtain relatively steeply rising characteristic immediately after the gate voltage $V_G$ is above 1.0 V. Namely, by making each angle formed by adjacent sides of the diffusion window above 150° (more than twelve-sided polygon), the rising of an electric current $I_{DS}$ characteristic is steeply sloped immediately after the transistor is turned on. This means that it is possible to a vertical MOS transistor having low on voltage and on resistance, and high speed switching capability.

Reference has been made with reference to an n-channel type vertical MOS transistor. Howeer, the same discussion is applicable to a vertical MOS transistor of a P-channel type.

As is clear from the foregoing description, according to the vertical MOS transistor of the invention, there is used a polygonal diffusion window formed so that each angle formed by adjacent sides is 150° or more in the process of a double diffusion for forming a channel region. Accordingly, the diffusion concentration in the lateral direction becomes uniform over the entire corners and side portions of the diffusion window. For this reason, when diffusion concentration is lowered in order to lower on-voltage, there is no possibility that leakage current does not occur locally at corner portions of the diffusion window. Further, conductive areas between the source and the drain are substantially concurrently formed over entire periphery of the channel. Accordingly, by steepening the rising of $V_G - I_{DS}$, it is possible to provide a vertical MOS transistor having low on-voltage and on-resistance, and high speed switching capability.

WHAT IS CLAIMED IS:

1.         A field effect transistor of the vertical MOS type comprising:

a semiconductor substrate of a first conductivity type; with a first electrode formed lower surface thereof;

a first well region of a second conductivity type oppopsite to said first conductivity type provided on the upper side of said semiconductor substrate and functioning as a channel region;

a second well region of a first conductivity type provided within said first well region with a second electrode formed theron; and

a gate electrode arranged on said first well region through an insulation film, said gate electrode extending over said semiconductor substrate of said first conductivity type and said second well region;

said both well regions being formed by a double diffusion through the same polygonal diffusion window designed so that each angle formed by two adjacent sides is $150^{\circ}$ or more.

2.         A field effect transistor of the vertical MOS type comprising:

a semiconductor substrate of a first conductivity type;

a first well region of a second conductivity type opposite to said first conductivity type provided on the upper side of said semiconductor substrate and functioning as a channel region;

a second well region of a first conductivity type provided within said first well region with a second electrtode formed thereon; and

a gate electrode arranged on said first well region through an insulating film, said gate electrode extending over said semiconductor substrate of said first conductivity type and said second well region;

said both well regions being  formed by a double diffusion through the same circular diffusion window.

- 14 -                                          0130508

3.          A field effect transistor of the vertical MOS type of
Claim 1, wherein
            said polygonal diffusion window is an aperture opened
in said gate electrode functioning also as resist for said double
diffusion.

4.          A field effect transistor of the vertical MOS type of
Claim 2, wherein
            said circular diffusion window is an aperture opened in
said gate electrode functioning also as resist for said double
diffusion.

5.          A field effect transistor of the vertical MOS type of
Claim 1, wherein
            said first electrode functions as a drain electrode;
said semiconductor substrate, as drain region; said second
electrode, as a source electrode; said second well region, as a
source region.

6.          A field effect transistor of the vertical MOS type of
Claim 2, wherein
            said first elctrode functions as a drain electrode;
said semiconductor substrate, as drain region; said second
electrode, as a source electrode; said second well region, as a
source region.

7.          A field effect transistor of the vertical MOS type of
Claim 2, wherein said semiconductor substrate is a silicon wafer.

8.          A field effect transistor of the vertical MOS type of
Claim 3, wherein said semiconductor substrate is a silicon wafer.

9.          A field effect transistor of the vertical MOS type of
Claim 7, wherein said semiconductor substrate is provided with an
epitaxial layer on the upper side thereof, and said both well
region are formed in said epitaxial layer.

10.         A field effect transistor of the vertical MOS type of
Claim 8, wherein said semiconductor substrate is provided with an
epitaxial layer on the upper side thereof, and said both well
regions are formed in said epitaxial layer.

11.         A field effect transistor of the vertical MOS type of Claim 9 furthur comprising a contact region of said second conductivity type formed in a central portion of said source region and being in contact with said first well region.

12.       A field effect transistor of the vertical MOS type of Claim 10 furthur comprising a contact region of said second conductivity type formed in a central portion of said source region and being in contact with said first well region.

FIG.1A

FIG.1B

FIG.1C

FIG.1D

0130508

FIG.1E

FIG.1F

FIG.1G

FIG.1H

FIG.1I

FIG.1J

4/7

# FIG.2

PRIOR ART

# FIG.3

PRIOR ART

## F I G.4
PRIOR ART

Diffusion window : hexagon
area of chip : 1mm²
V_DS : 50mV

## F I G.5
PRIOR ART

6/7

0130508

FIG.6A

FIG.6B

FIG.6C

FIG.6D

FIG.6E

FIG.6F

FIG.7

area of chip : 1mm²

$V_{DS}$ : 50mV

European Patent Office

**EUROPEAN SEARCH REPORT**

Application number

EP 84 10 7208

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | EP-A-0 037 105 (SIEMENS) <br> * Claims 1,2 * | 1 | H 01 L 29/08 <br> H 01 L 29/78 |
| A | GB-A-2 020 484 (RCA) <br> * Page 1, lines 74-91 * | 1 | |
| A | IEEE TRANSACTIONS ON ELECTRON DEVICES, vol. ED-28, no. 9, September 1981, New York, USA; P.L. HOWER et al. "Comparison of Various Source-Gate Geometries for Power MOSFET's, pages 1098-1101" " Figure 3 * | 2 | |
| A | GB-A-2 033 658 (INTERNATIONAL RECTIFIER) <br> * Page 4, lines 18-42; page 5, lines 47-76 * | 3,4 | **TECHNICAL FIELDS SEARCHED (Int. Cl. ³)** <br><br> H 01 L 21/22 <br> H 01 L 29/08 <br> H 01 L 29/52 <br> H 01 L 29/78 |

The present search report has been drawn up for all claims

| Place of search <br> BERLIN | Date of completion of the search <br> 10-09-1984 | Examiner <br> GIBBS C.S. |
|---|---|---|